**Europäisches Patentamt**

**European Patent Office**

**Office européen des brevets**

(19)

(11) Veröffentlichungsnummer: **0 355 498**

**A1**

# (12) EUROPÄISCHE PATENTANMELDUNG

(21) Anmeldenummer: **89114191.3**

(22) Anmeldetag: **01.08.89**

(51) Int. Cl.⁴: **G01R 15/04 , H01B 17/64 , H01B 17/14**

(30) Priorität: **18.08.88 DE 3828016**

(43) Veröffentlichungstag der Anmeldung:
**28.02.90 Patentblatt 90/09**

(84) Benannte Vertragsstaaten:
**DE FR IT NL SE**

(71) Anmelder: **Sachsenwerk Aktiengesellschaft**
**Einhauser Strasse 9**
**D-8400 Regensburg 1(DE)**

(72) Erfinder: **Stegmüller, Karl, Dipl.-Ing.**
**Galgenberg-West 11**
**D-8401 Wiesent(DE)**
Erfinder: **Reichl, Erwin**
**Spessartstrasse 4**
**D-8409 Tegernheim(DE)**

(74) Vertreter: **Breiter, Achim, Dipl.-Ing.**
**AEG Aktiengesellschaft, Theodor-Stern-Kai 1**
**D-6000 Frankfurt am Main 70(DE)**

(54) **Isolierteil, vorzugsweise als Stützisolator in einem Spannungsteiler für Hochspannungsanlagen.**

(57) Ein vorzugsweise als Stützisolator (11) verwendetes Isolierteil (11) weist durch geeignete Zusätze eine geringe elektrische Leitfähigkeit auf und ist im Kopfteil (21) sowie im Sockel (5) mit Metallarmaturen (12,13) versehen und bildet einen ohmschen Spannungsteiler. Um dabei ein definiertes Teilerverhältnis zu erreichen, ist im Bereich der Fußarmatur (13) in den Isolierkörper (20) eine Elektrode (25) eingefügt, die mit einem gegen geerdete Gestellteile (17) der Anlage isolierten, elektrischen Anschluß (27) verbunden ist und die sich über einen wesentlichen Teil der Querschnittsfläche des Isolierkörpers (20) erstreckt. Zwischen die Elektrode (25) und dem Endpotential ist eine Meß- und/oder Anzeigeanordnung (34) geschaltet zur Kontrolle des Spannungszustands auf der HS-Seite der Hochspannungsanlage.

## FIG.1

## Isolierteil, vorzugsweise als Stützisolator in einem Spannungsteiler für Hochspannungsanlagen

Die Erfindung betrifft ein Isolierteil gemäß dem Patent... (Patentanmeldung P 38 04 381.5).

Gegenstand des Hauptpatents (P...) ist ein Isolierteil mit begrenzter elektrischer Leitfähigkeit, das in Hochspannunganlagen z. B. neben der Funktion eines Stützisolators oder eines Steckerteils gleichzeitig eine Spannungsteilerfunktion für eine angeschaltete Meß- oder Anzeigeanordnung ausübt Dabei ist im Kopfteil des Isolierteils eine Armatur vorgesehen, die mit hochspannungsführenden aktiven Leitungsteilen verbunden ist und dieselben stützt Im Fußteil des Isolierteils ist ebenalls eine Metallarmatur vorgesehen, die der mechanischen Befestigung an geerdeten Gerüstteilen der Hochspannungsanlage dient Außerdem ist diese Fußarmatur gegenüber geerdeten Teilen isoliert und mit einem elektrischen Anschluß versehen, der mit der Meß- oder Anzeigeeinrichtung verbunden ist. Nachdem die fußseitige Stirnfläche des Isolierteils mit geerdeten Teilen in Berührung tritt, ist zwischen der kopfseitigen Metallarmatur und der geerdeten fußseitigen Stirnfläche eine ohmsche Widerstandsstrecke ausgebildet, an der die fußseitige Metallarmatur als Abgriff wirkt Das Isolierteil bildet somit einen ohmschen Spannungsteiler.

Der Erfindung liegt die Aufgabe zugrunde, bei einem gemäß dem Hauptpatent ausgebildeten Isolierteil Maßnahmen zu treffen, durch die ein definiertes Spannungsteilerverhältnis erreicht wird

Die Lösung dieser Aufgabe erfolgt gemäß der Erfindung durch die kennzeichnenden Merkmale des ersten Anspruchs.

Bei einer Ausgestaltung eines Isolierteils gemäß der Erfindung wird durch die eingefügte Elektrode die Möglichkeit geschaffen, das Spannungsteilerverhältnis durch Ändern des Abstandes zwischen der fußseitigen Stirnfläche und dem Einbettungsort der Elektrode auf einen gewünschten Wert einzustellen. Die Geometrie und Anordnung der Fußarmatur kann dann in erster Linie nach den mechanischen Festigkeitserfordernissen bemessen werden. Zweckmäßig ist dabei im Bereich der fußseitigen und gegebenenfalls auch der kopfseitigen Stirnfläche des Isolierkörpers eine Zusatzelektrode vorgesehen, die an den Stirnflächen als Metallisierung oder eingebettetes Gitter ausgebildet sein kann. Die kopfseitige Zusatzelektrode ist dabei mit der benachbarten Metallarmatur und die fußseitige Zusatzelektrode mit Massepotential verbunden Dadurch wird der gesamte Querschnitt des bedingt elektrisch leitfähigen Isolierkörpers definiert in den Stromkreis einbezogen. Durch diese Maßnahmen wird eine mögliche geringfügige Ablösung des Einbettungsmaterials von den Armaturen bei hoher mechanischer Belastung der Isolierteile unwirksam gemacht Insbesondere kann durch die Anordnung der als Spannungsteilerabgriff wirkenden Elektrode das Spannungsteilerverhältnis so eingestellt werden, daß vorgegebene Sicherheits- oder Prüfspannungen auch im Leerlauffall, also ohne angeschlossene, äußere Beschaltung am zugeordneten elektrischen Anschluß nicht überschritten werden. Zudem wird durch die in den Isolierkörper eingefügt Elektrode der Vorteil erzielt, daß ein konstanter Fußwiderstand des Spannungsteilers erreicht wird und dadurch eine Überprüfung der Funktionsfähigkeit des Spannungsteilers durch äußere Meßeinrichtungen durchgeführt werden kann. Aufgrund des bestimmten Spannungsteilerverhältnisses läßt sich so auch ein Kurzschluß oder auch ein Drahtbruch im Meßsystem einwandfrei erkennen. Vorzugsweise ist die als Spannungsteilerabgriff wirkende Elektrode mit der Fußarmatur verbunden, die ihrerseits gegenüber elektrisch geerdeten Teilen isoliert und mit einem elektrischen Anschluß verbunden ist Dabei kann die Schraube, mit welcher der Stützer an Gerüstteilen der Anlage festgesetzt wird, als elektrischer Anschluß herangezogen werden, wenn die Schraube gegen die Gerüstteile elektrisch isoliert wird. Vorzugsweise ist die Fußarmatur gegenüber der fußseitigen Stirnfläche des Isolierteils in den Isolierkörper zurückversetzt, so daß zwischen dieser Stirnfläche und der Metallarmatur eine Widerstandsstrecke gebildet ist. Es ist jedoch auch möglich, die Fußarmatur bündig mit der fußseitigen Stirnfläche abschließen zu lassen und die den Spannungsteilerabgriff bildende Elektrode mit einem eigenständigen elektrischen Anschluß zu versehen, ohne die Metallarmatur und die Elektrode unmittelbar elektrisch miteinander zu verbinden. Die Fußarmatur kann dann direkt mit den betreffenden Gerüstteilen in Kontakt stehen und damit verschraubt werden. Daneben kann benachbart zur fußseitigen Stirnfläche und auch zur kopfseitigen Stirnfläche eine Zusatzelektrode vorgesehen werden, von welchen die kopfseitige Zusatzelektrode mit der benachbarten Metallarmatur und die fußseitige Zusatzelektrode mit geerdeten Teilen verbunden sein kann. Es ist dann zweckmäßig, der fußseitigen Zusatzelektrode ein eigenes elektrisches Anschlußstück zuzuordnen. Diese fußseitige Zusatzelektrode kann dann in der Nähe oder am Eingang der angeschalteten Meß- oder Anzeigeanordnung geerdet werden, so daß die Spannungserfassung auch dann noch einwandfreie Meßwerte liefert, wenn durch Anhebung des Erdpotentials am Einbauort des Stützers, beispielsweise durch Erdschluß oder durch einen stromstarken Überschlag am oder in der Nähe des Einbauortes des Stützers eine Differenzspannung zum Erdpotential der Meß- oder Anzeigeeinrichtung entsteht. Um dabei Verfälschungen des Meßergebnisses zu vermeiden, wird die fußseitige Stirnfläche gegenüber geerdeten Gerüstteilen isoliert. Die fußseitige Zusatzelektrode schafft im übrigen auch definierte Verhältnisse für das Massepotential, das selbst bei metallisierter fußseitiger Stirnfläche durch Schutzlacke, Kleber oder Korrosion undefinierte Werte annehmen kann. Auch wirken sich dann Spannungsdifferenzen zwischen dem Erdungspunkt der Meß- oder Anzeigeanordnung und dem Befestigungsort des Isolierteils nicht aus. Zur Auswertung der Spannung am Spannungsteiler kann an den elektrischen Anschluß der Elektrode die Serienschaltung aus einem Widerstand, einem Kondensator und einem weiteren, einseitig geerdeten Widerstand zur Anwendung gelangen, die Teil einer Meß-und/oder Anzeigeanordnung ist, wobei parallel zum Kondensator ein Ruhekontakt und parallel zum weiteren Widerstand die Reihenschaltung aus einem Arbeitskontakt und einem elektrischen Meß- und/oder Anzeigegerät liegt. Den beiden Schaltern ist dabei ein gemeinsames Betätigungselement zugeordnet. Bei unbetätigten Kontakten ist das Meß- oder Anzeigegerät nicht beansprucht und kann daher mit einem LCD-Element ausgerüstet sein, dessen Lebensdauer bei Dauerbetrieb kürzer als die Lebensdauer der Schaltanlage ist, vorwiegend jedoch nur sporadisch eingeschaltet wird und daher eine sehr hohe Lebensdauer erreicht. Zudem ist das Meß- oder Anzeigegerät dadurch vor Überspannungen geschützt. Auch können durch den eingefügten Kondensator beim Meßvorgang keine Gleichspannungen auf das Meß- oder Anzeigegerät gelangen Daneben können über der Serienschaltung durch dort angeschlossene Meßbuchsen mit einfachen Meßgeräten Kontroll-Spannungs- oder Widerstandsmessungen am Fußwiderstand des Spannungsteilers bzw. in der Meßschaltung ausgeführt werden, wobei auch die wichtige Überprüfung aller Verbindungsleitungen zwischen Isolierteil und Meß- und Anzeigeanordnung mit vorgenommen wird.

Die Erfindung ist nachfolgend anhand von Ausführungsbeispielen näher erläutert.

Es zeigt:

Figur 1 ein als Stützisolator ausgebildetes Isolierteil mit beschränkter elektrischer Leitfähigkeit und einer eingebetteten Elektrode,

Figur 2a eine Darstellung des Fußteils des Stützisolators, ergänzt um eine Zusatzelektrode,

Figur 2b eine Darstellung des Kopfteils des Stützisolators ergänzt um eine Zusatzelektrode,

Figur 3 ein Fußteil des Stützisolators in Verbindung mit einem Gestellteil und

Figur 4 eine Meß- und Anzeigeanordnung in Verbindung mit dem Stützisolator.

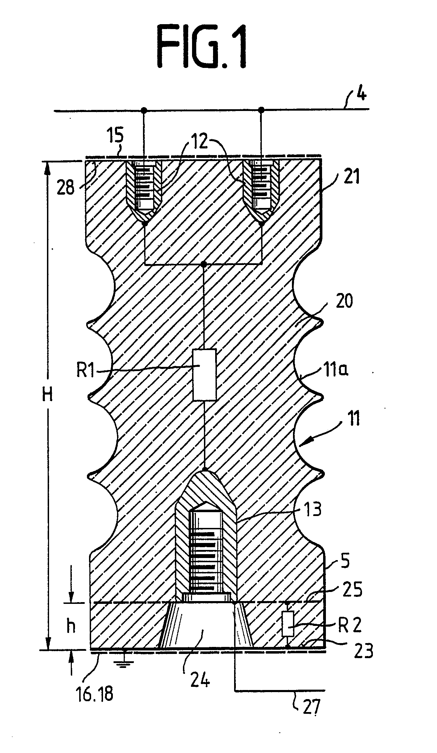

Ein Stützisolator 11 weist einen Isolierkörper 20 mit begrenzter elektrischer Leitfähigkeit auf, die durch elektrisch leitfähige Zusätze zu dem den Isolierkörper 20 bildenden Kunststoff hervorgerufen wird. In dem im wesentlichen zylindrischen, an seiner Mantelfläche Wellungen aufweisenden Isolierkörper 20 sind im Kopfarmaturen 12 vorgesehen, die mit einer an Hochspannung liegenden Sammelschiene 4 elektrisch und mechanisch verbunden sind. (Figur 1) In dem als Sockel 5 dienenden Fußteil des Isolierkörpers 20 befindet sich in zentraler Anordnung eine Fußarmatur 13, mit deren Hilfe über eine Schraube 22 der Stützisolator 11 mit der entsprechenden Stirnfläche 23 gegen eine geerdete Grundfläche bzw. gegen Gestellteile 17 einer Hochspannungsanlage zur mechanischen Halterung spannbar ist. In die Stirnfläche 23 ist dabe eine Vertiefung 24 eingeformt, von deren Grund aus sich die Fußarmatur 13 in den Isolierkörper 20 erstreckt. Im Bereich des Sockels 5 befindet sich innerhalb der Querschnittsfläche des Isolierkörpers 20 eine in den Isolierkörper 20 integrierte Elektrode 25, die als Gitter ausgebildet sein kann und über den wesentlichen Querschnitt des Isolierkörpers 20 reicht. Vorzugsweise verläuft diese Elektrode 25 parallel zur Stirnfläche 23 und liegt im Höhenbereich der benachbarten Fußarmatur 13. Wegen der gemäß dem Hauptpatent (P38 04 381.5) durch leitfähige Zusätze zum Isolierstoff eingestellten, sehr geringen elektrischen Leitfähigkeit des Isolierkörpers 20 stellt der an sich als Isolierteil wirkende Stützisolator 11 auch einen definierten ohmschen Widerstand dar, bei dem ein Teilwiderstand R1 zwischen den Metallarmaturen 12,13 und ein weiterer Teilwiderstand R2 zwischen der Fußarmatur 13 und der benachbarten, entweder mit einer Metallisierung 18, einer metallischen Platte 16 oder durch die Gestellteile 17 kontaktierten Stirnfläche 23 gebildet ist. Das Widerstandsverhältnis der Widerstände R1 und R2 bestimmt dabei das Spannungsteilerverhältnis und damit die am Widerstand R2 anliegende Spannung im Betrieb. Dabei ist die Elektrode 25 elektrisch leitend mit der Fußarmatur 13 verbunden. Die Elektrode 25 schafft durch eine definierte geometrische Lage ein entsprechend definiertes Teilerverhältnis der elektrischen Widerstandswerte.

Da die Fußarmatur 13 durch die Vertiefung 24 gegenüber der Stirnfläche 23 zurückversetzt ist, wird der Widerstand R2 auch nicht durch diese Fußarmatur 13 elektrisch überbrückt.

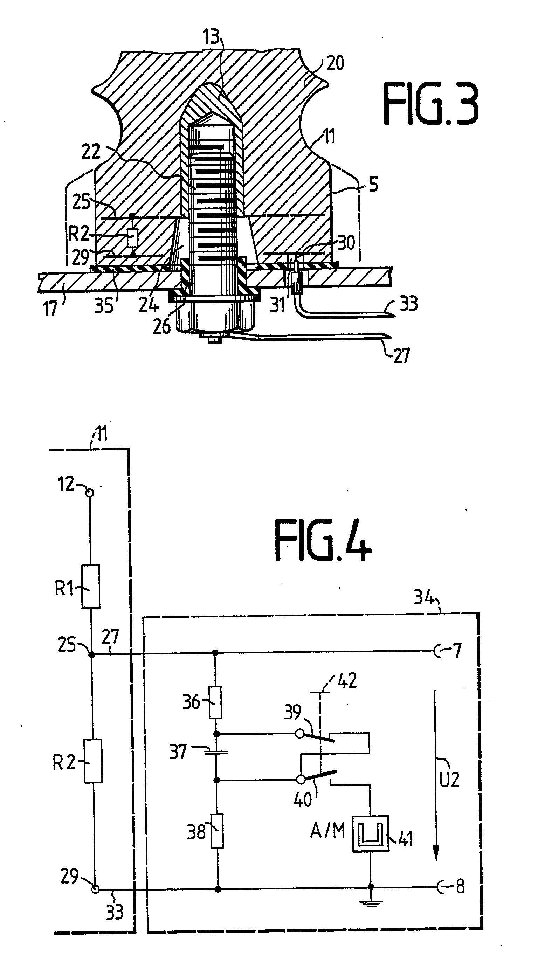

Wenn die Elektrode 25 mit der Fußarmatur 13 elektrisch verbunden ist, kann diese Metallarmatur 13 als elektrischer Anschluß für den Abgriff der am Widerstand R2 anstehenden Spannung benutzt werden. Dann ist es erforderlich, die Schraube 22 durch eine Isolierbuchse 26 gegenüber den geerdeten Gestellteilen 17 elektrisch zu isolieren. (Figur 3) Die Schraube 22 kann dann mit einem elektrischen Anschluß 27 verbunden werden, sofern nicht die Fußarmatur 13 mit einem eigenen elektrischen Anschluß ausgestattet ist.

Daneben ist es aber auch möglich, die Elektrode 25 nicht direkt elektrisch mit der Fußarmatur 13 zu verbinden, sondern ihr einen separaten elektrischen Anschluß zuzuordnen. Dann kann die Fußarmatur 13 geerdet sein. Sie kann zudem bis in die Ebene der Stirnfläche 23 vorgezogen werden, so daß das mechanische Spannungsmoment der Schraube 22 nicht über den Isolierkörper 20 aufgefangen werden muß. Die am Widerstand R2 abfallende Teilspannung wird dann nur an der in den Isolierkörper 20 eingebetteten Elektrode 25 abgegriffen.

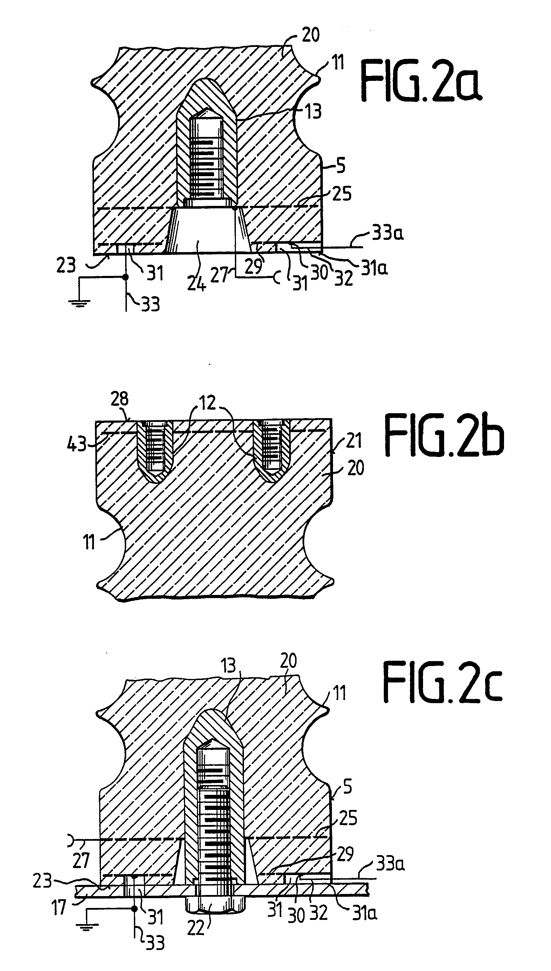

Darüber hinaus ist im Isolierkörper 20 nahe zur fußseitigen Stirnfläche 23 und gegebenenfalls auch parallel zur kopfseitigen Stirnfläche 28 des Isolierkörpers 20 je eine Zusatzelektrode 29 bzw. 43 vorgesehen, die parallel zur jeweiligen Stirnfläche verläuft und eventuell die den Stirnflächen 23,28 zugeordneten metallischen Platten 15,16 bzw. die Metallisierung 18 ersetzen. (Figur 2a, 2b) Diese Zusatzelektroden 29 bzw. 43 schaffen eine Verkleinerung des Widerstands R 1 bei gleichzeitiger eine den Querschnitt des Isolierkörpers 20 gleichmäßig beaufschlagender Stromverteilung, wobei die kopfseitige Zusatzelektrode mit den Kopfarmaturen 12 und die fußseitige Zusatzelektrode 29 mit geerdeten Teilen verbunden sein kann. Hierzu weist die fußseitige Zusatzelektrode 29 ein eigenes elektrisches Anschlußstück 30 auf, das durch eine zur Stirnseite 23 hin offene Ausnehmung 31 im Sockel 5 zugänglich ist. (Figur 3) Von der Ausnehmung 31 kann auch ein nach außen gerichteter Kanal weglaufen, durch den eine Anschlußleitung 33 geführt werden kann. (Figur 2a) Die Zusatzelektrode 29 befindet sich dabei räumlich zwischen der Elektrode 25 und der Stirnseite 23. Der Widerstand R2, an dem die Meßspannung abgegriffen wird, ist dann zwischen diesen beiden Elektroden 25,29 gebildet. Wenn die fußseitige Zusatzelektrode 29 nicht unmittelbar im Bereich des Stützisolators 11 geerdet wird, sondern an eine entfernt davon angeordnete Meß- und/oder Anzeigeanordnung 34 geführt wird, ist zweckmäßig zwischen die Stirnfläche 23 und die geerdeten Gestellteile 17 eine Isolierschicht 35 eingefügt, die insbesondere im Erdschlußfall mögliche Potentialanhebungen der Gestellteile für die Messung oder Anzeige unwirksam machen soll. (Figur 3).

Die Meß- und Anzeigeanordnung 34 ist mit den Anschlüssen 27 und 33 an den Widerstand R2 angeschaltet. Dabei sind letzteren Prüfklemmen 7 bzw. 8 für den Anschluß externer Meßgeräte zugeordnet. An den elektrischen Anschluß 27 der Elektrode 25 ist innerhalb der Meß- und Anzeigeanordnung 34 die Serienschaltung aus einem Widerstand 36, einem Kondensator 37 und einem weiteren, einseitig geerdeten Widerstand 38 angeschaltet, wobei die geerdete Leitung hier identisch mit der Anschlußleitung 33 der Zusatzelektrode 29 ist. Parallel zum Kondensator 37 liegt ein Ruhekontakt 39 und parallel zum weiteren Widerstand 38 die Reihenschaltung aus einem Arbeitskontakt 40 sowie einem elektrischen Meß- und/oder Anzeigegerät 41, das als LCD-Instrument ausgebildet ist. Den Kontakten 39,40 ist dabei ein gemeinsames Betätigungselement 42 zugeordnet. (Figur 4) Liegt an der Sammelschiene 4 Hochspannung an, dann wird diese Spannung gegen Erde entsprechend dem Widerstandsverhältnis der Widerstände R1 und R2 geteilt Die am Widerstand R2 anliegende Meßspannung wird nach der Umschaltung des Betätigungselements 42, bei der der Ruhekontakt 39 geöffnet und der Arbeitskontakt 40 geschlossen wird, im Gerät 41 zur Anzeige bebracht; durch den im Meßkreis enthaltenen Kondensator 37 werden dabei aber lediglich Wechselspannungen erfaßt. Eventuell auftretende Gleichspannungen laden den Kondensator 37 auf, ohne dabei einen Stromfluß durch das Meß- und/oder Anzeigegerät 41 fließen zu lassen.

Der Kondensator 37 ist sonst zur Vermeidung eines unzulässigen Gleichspannungsaufbaus auf der Meßleitung 27 kurzgeschlossen. An den Prüfklemmen 7,8 kann im übrigen mit externen Meßgeräten die Anzeige des Geräts 41 überprüft, der Widerstand R2 bei gedrückter Betätigungstaste 42 gemessen oder die gesamte Schaltung auf Drahtbruch geprüft werden

## Ansprüche

1. Isolierteil, vorzugsweise als Stützisolator, in einem ohmschen Spannungsteiler für Hochspannungsanlagen zur Feststellung oder Messung der Hochspannung mit einem Isolierkörper aus Kunststoff, dem leitfähige Füllmittel zur Verringerung des ohmschen Widerstandes zugesetzt sind und der Bestandteil des Spannungsteilers ist, sowie im Kopfteil wie im Fußteil eingeformte Metallarmaturen zur Verbindung des Kopfteils mit hochspannungsseitig zu stützenden aktiven Teilen und des Fußteils zur mechanischen Halterung an geerdeten Gerüstteilen einer Anlage aufweist, nach Patent...-(Patentanmeldung 38 04 381.5), dadurch gekennzeichnet, daß im Bereich der Fußarmatur (13) in den Isolierkörper (20) eine Elektrode (25) eingefügt ist, die mit einem gegen geerdete Teile (17) isolierten elektrischen Anschluß (27) verbunden ist und die sich über einen wesentlichen Teil der Querschnittsfläche des Isolierkörpers (20) erstreckt.

2. Isolierteil nach Anspruch 1, dadurch gekennzeichnet, daß die Elektrode (25) mit der Fußarmatur (13) verbunden ist und daß die Armatur (13) von elektrisch geerdeten Teilen (17) getrennt sowie mit dem elektrischen Anschluß (27) verbunden ist

3. Isolierteil nach Anspruch 1 oder 2, dadurch gekennzeichnet, daß die Fußarmatur (13) einer Stirnfläche (23) des Isolierkörpers zugeordnet ist, die den geerdeten Gestellteilen (17) zugewandt ist, und daß die Armatur (13) gegenüber dieser fußseitigen Stirnfläche (23) in einer Vertiefung (24) zurückgesetzt ist

4. Isolierteil nach Anspruch 1 oder einem der folgenden, dadurch gekennzeichnet, daß die Elektrode (25) als Gitter ausgebildet ist, das in den Isolierkörper eingebettet ist.

5. Isolierteil nach Ansoruch 1 oder einem der folgenden, dadurch gekennzeichnet, daß die Elektrode (25) parallel zur benachbarten Stirnfläche (23) des Isolierkörpers verläuft.

6. Isolierteil nach Ansoruch 1, 4 oder 5, dadurch gekennzeichnet, daß die Fußarmatur (13) geerdet und die Elektrode (25) davon getrennt sowie mit einem seperaten Anschluß (27) elektrisch verbunden ist

7. Isolierteil nach Anspruch 1 oder einem der folgenden, dadurch gekennzeichnet, daß zwischen der Elektrode (25) und der fußseitigen Stirnwand (23) des Isolierkörpers eine Zusatzelektrode (29) vorgesehen ist, die ein eigenes elektrisches Anschlußstück (30) aufweist.

8. Isolierteil nach Ansoruch 7, dadurch gekennzeichnet, daß zwischen der fußseitigen Stirnwand (23) und benachbarten geerdeten Teilen (17) eine elektrische Isolierschicht (35) vorgesehen ist

9. Isolierteil nach Ansoruch 7 oder 8, dadurch gekennzeichnet, daß das Anschlußstück (30) in einer Aussparung (31) in der fußseitigen Stirnfläche (23) angeordnet ist.

10. Isolierteil nach Anspruch 9, dadurch gekennzeichnet, daß die Aussparung (31) über einen nach außen verlaufenden Kanal (32) zur Mantelfläche des Isolierkörpers (20) hin offen ist

11. Isolierteil nach Ansoruch 1 oder einem der folgenden, dadurch gekennzeichnet, daß an den elektrischen Anschluß (27) der Elektrode (25) die Serienschaltung aus einem Widerstand (36), einem Kondensator (37) und einem weiteren, einseitig geerdeten Widerstand (38) einer Meß-und/oder Anzeigeanordnung (34) angeschaltet ist, daß parallel zum Kondensator (37) ein Ruhekontakt (39) und parallel zum weiteren Widerstand (38) die Reihenschaltung aus einem Arbeitskontakt (40) und einem elektrischen Meß- und/oder Anzeigegerät (41) liegt und daß den Kontakten (39,40) ein gemeinsames Betätigungselement (42) zugeordnet ist.

12. Isolierteil nach Anspruch 7 und 11, dadurch gekennzeichnet, daß die Zusatzelektrode (29) über die Anschlußleitung (33) mit den geerdeten Teilen der Meß- und/oder Anzeigeanordnung (34) elektrisch verbunden ist

13 Isolierteil nach Anspruch 11 oder 12, dadurch gekennzeichnet, daß an die Endpunkte der Serienschaltung (36,37,38) Prüfklemmen (7,8) angeschlossen sind.

14. Isolierteil nach Anspruch 1 oder einem der folgenden, dadurch gekennzeichnet, daß parallel zur kopfseitigen Stirnseite (28) eine Zusatzelektrode (43) in den Isolierkörper (20) eingefügt ist.

15. Isolierteil nach Anspruch 1 oder einem der folgenden, dadurch gekennzeichnet, daß der Isolierkörper (20) im Bereich der fußseitigen und/oder der kopfseitigen Stirnfläche (23,28) mit einer Metallplatte (15,16) oder Metallisierung (18) versehen ist.

# FIG.1

FIG.2a

FIG.2b

FIG.2c

FIG.3

FIG.4

Europäisches
Patentamt

**EUROPÄISCHER RECHERCHENBERICHT**

Nummer der Anmeldung

EP 89114191.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | <u>DE - A1 - 3 329 748</u><br>(SIEMENS)<br>* Fig. 1-3 *<br>-- | 1 | G 01 R 15/04<br>H 01 B 17/64<br>H 01 B 17/14 |
| A | <u>EP - A1 - 0 216 056</u><br>(FELTEN & GUILLEAUME)<br>* Patentanspruch 1 *<br>-- | 1 | |
| A | <u>DE - A1 - 2 833 918</u><br>(SIEMENS)<br>* Patentanspruch 1 *<br>---- | 1 | |

| | RECHERCHIERTE SACHGEBIETE (Int. Cl.4) |
|---|---|
| | G 01 R 15/00<br>H 01 B 17/00 |

Der vorliegende Recherchenbericht wurde für alle Patentansprüche erstellt.

| Recherchenort | Abschlußdatum der Recherche | Prüfer |
|---|---|---|
| WIEN | 22-11-1989 | KUNZE |